# EUROPEAN PATENT APPLICATION

(11) **EP 1 883 096 A1**
(43) Date of publication of application: **30.01.2008**
(21) Application number: 07112812.8
(22) Date of filing: 20.07.2007
(51) Int. Cl.: H01J 37/20, H01L 21/68, H01L 21/687

(54) **Transfer mechanism for transferring a specimen**

(30) Priority: 26.07.2006 EP 06117867
(71) Applicant: FEI COMPANY, Hillsboro, Oregon 97124-5793 (US)
(72) Inventor: Van Gaasbeek, Erik, 7271 KB, Borculo (NL); Dona, Pleun, 5504 KN, Veldhoven (NL); Barends, Paul, 5061 LB, Oisterwijk (NL); Van Hees, Ian, 5301 JG, Zaltbommel (NL); Van de Water, Jeroen, 4158 CN, Deil (NL); Van den Oetelaar, Johannes, 5644 BE, Eindhoven (NL)
(74) Representative: Bakker, Hendrik

(57) **Abstract**

The invention relates to a transfer mechanism for transferring a specimen (2) from a first position in a first holder (40) to a second position in a second holder (10) and/or vice versa, each holder (10, 40) equipped to detachably hold the specimen, the transfer of the specimen between the holders taking place in a transfer position different from the second position, characterized in that when the specimen is transferred between the holders (10, 40) a mechanical guidance mechanism positions the holders with a mutual accuracy higher than the mutual accuracy in the second position, and said mechanical guidance mechanism not positioning at least one of the holders (10, 40) when the specimen is in the second position.

The mechanical guidance mechanism may comprise extra parts (50).

At least one of the holders (40) may be equipped to hold a multitude of specimens.

## Description

The invention relates to a transfer mechanism for transferring a specimen from a first position in a first holder to a second position in a second holder and/or vice versa, each holder equipped to detachably hold the specimen, the transfer of the specimen between the holders taking place in a transfer position different from the second position.

Such a transfer mechanism is known from "Robotic grid loading system for a transmission electron microscope", C.S. Potter et al., J. Struct. Biol. 146(3), June 2004, pages 431-440.

Such transfer mechanisms are in use as part of or in conjunction with e.g. particle-optical instruments. Such particle-optical instruments are used for the inspection and/or analysis of specimens, e.g. specimens taken out of a wafer during the manufacturing process of the wafer, or e.g. biological tissues.

The known transfer mechanism works in conjunction with a Transmission Electron Microscope (TEM), where it enables automatic loading and unloading of specimens in the microscope.
As known to the person skilled in the art, specimens to be inspected in a TEM must be extremely thin. A typical thickness of less than 100 nm, more preferably less than 50 nm is used. To handle such a thin specimen the specimen is often mounted on a specimen carrier comprising e.g. a mesh, the mesh supporting the specimen. The most widely used specimen carriers have a diameter of 3 mm and a thickness between appr. 10 and 25 µm. Obviously these specimen carriers are quite fragile.

The known transfer mechanism comprises a grid tray workstation and a robotic arm equipped with a gripper.
The robotic arm is a 6-axis articulate arm with a reach of 665 mm and a repeatability of positioning of +/- 20 µm. On the robotic arm a multi-force/torque sensor is mounted, on which a grid gripper is mounted.

The grid tray workstation accepts a grid tray, said tray containing up to 96 specimen carriers held in depressions. The tray is precisely positioned using registration holes.
The known transfer mechanism further comprises a specimen holder workstation, which accepts a specimen holder for the TEM. A pin on the specimen holder precisely registers the specimen holder in the specimen holder workstation. A pneumatic vice holds the specimen holder firmly in place.
The specimen holder is of a type that accepts a grid in a cut-out and holds the grid with a spring-loaded lever. The specimen holder workstation has provisions to operate the lever.
Operation of the known transfer system comprises positioning the grid gripper to a specific grid in the grid tray, gripping the grid, transporting the grid to the specimen holder and inserting the grid in the cut-out of the specimen holder.
To enable the grid gripper to pick up a grid the gripper must be very well positioned with respect to the grid: the grid is very fragile and gripping the grid in a mis-aligned position could easily result in damaged grids. This is the reason for the high positional repeatability of the robot of +/- 20 µm.

The known transfer mechanism also has provisions to insert the specimen holder in the TEM.

It is remarked that a positional accuracy of 20 µm over a reach of e.g. 665 mm, as used in the known transfer mechanism, corresponds to e.g. an angular accuracy of 30 µrad, which requires a very sophisticated and stable guidance mechanism. A transfer mechanism equipped with a robot with the before mentioned accuracy and reach is therefore very expensive. Also, the resulting transfer mechanism is, due to these demands, voluminous and heavy, which makes this transfer mechanism unsuited to be mounted on e.g. a TEM. The known transfer mechanism is therefore mounted separate from the TEM. This, however, introduces extra problems when interfacing the transfer mechanism with the TEM, as their mutual position is not well defined.

The invention aims to provide a smaller, lighter and less expensive transfer mechanism than the known transfer mechanism.

To that end the invention is characterized in that, when the specimen is transferred between the holders, a mechanical guidance mechanism positions the holders with a mutual accuracy higher than the mutual accuracy in the second position, and said mechanical guidance mechanism not positioning at least one of the holders when the specimen is in the second position.

The invention is based on the insight that during transfer both holders contact the specimen simultaneously. Due to the fragility of the specimen the positional accuracy between the holders must then be high. However, the high positional accuracy need not be maintained when the specimen can only be contacted by one holder.
Positioning the two holders at one specific position with an accuracy of e.g. 20 µm (as achieved in the known transfer mechanism) is relatively easily achieved with a compact and light mechanical guidance mechanism, e.g. equipping the two holders with cooperating parts, that form the guidance mechanism when the two holders are pushed together.

In an embodiment of the transfer mechanism according to the invention the mechanical guidance mechanism is formed by the cooperation of the shape of the holders.
By e.g. equipping the two holders with cooperating parts which form the guidance mechanism, and guide the two holders when the two holders are pushed together, a simple and reliable mechanical guidance mechanism is created.

In another embodiment of the transfer mechanism according to the invention the mechanical guidance mechanism is formed by the cooperation of the two holders with a separate member, said member detachably contacted by both holders when the specimen is transferred.

In this embodiment the two holders cooperate with a separate member. This separate member can guide the holders when they are pushed against the member, but the separate member can also clamp the holders in a specific position, after which the specimen can be transferred.
An additional advantage is that, when the separate member is positioned with respect to an apparatus, such as a camera, the position of the holders with respect to that apparatus is also well defined during transfer, enabling e.g. monitoring of the transfer.

In yet another embodiment of the transfer mechanism according to the invention at least one holder is equipped to hold a multitude of specimens.
When one of the holders is equipped to hold a multitude of specimens, this multitude of specimens can be automatically processed, e.g. by automatic inspection in a TEM.

In yet another embodiment of the transfer mechanism according to the invention the transfer mechanism is equipped to operate in a vacuum environment.

In still yet another embodiment of the transfer mechanism according to the invention mutual accuracy of the holders during the transfer of the specimen must be less than 50 µm in any direction.

The invention will now be elucidated with figures, in which corresponding reference numerals indicate corresponding features. To that end:
Figure 1 schematically depicts a cross-section of the transfer mechanism according to the invention, in which the geometry of the holders forms the mechanical guidance system.
Figure 2 schematically depicts a cross-section of the transfer mechanism according to the invention, in which the holders cooperate with a separate member to form the mechanical guidance system.
Figure 3 schematically depicts a cross-section of the transfer mechanism according to the invention, in which the specimen is transferred between two axles moving perpendicular to each other.
Figure 4 schematically depicts a cross-section of the transfer mechanism according to the invention, in which one of the holders is equipped to hold a multitude of specimens.

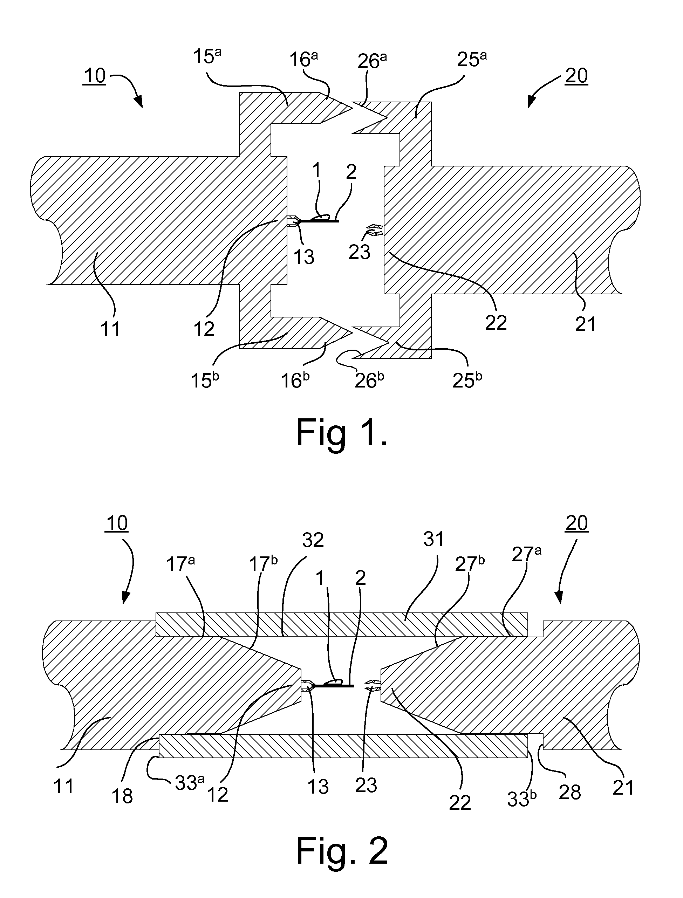

Figure 1 shows schematically a cross-section of the transfer mechanism according to the invention, in which the geometry of the holders forms the mechanical guidance system.
The specimen 1 is mounted on a TEM specimen grid 2 in a fashion known to the person skilled in the art.
A first holder 10 comprises an axle 11 with an extremity 12. Extremity 12 is equipped with a gripper 13. Such a gripper is commercially available, e.g. the Zyvex NanoEffector™ Microgripper model BB series from Zyvex Corporation. Holder 10 is further equipped with two extremity 15^{a} and 15^{b}, which show convex surfaces 16^{a} and 16^{b}.
Likewise the second holder 20 comprises an axle 21 with an extremity 22. Extremity 22 is equipped with a gripper 23. The second holder 20 is further equipped with two extremities 25^{a} and 25^{b}, which show concave surfaces 26^{a} and 26^{b} intended to cooperate with the convex surfaces 16^{a} and 16^{b} of extremities 15^{a} and 15^{b}.

When moving the two holders 10 and 20 towards each other the two cooperating surfaces 16^{a} and 26^{a} of extremities 15^{a} and 25^{a}, and the two cooperating surfaces 16^{b} and 26^{b} of extremities 15^{b} and 25^{b} will align the two axles 11 and 21 and thereby position the grippers 13 and 23 relative to each other with a much higher accuracy than when the features 15^{a}, 15^{b}, 25^{a} and 25^{b} would not be present.

Assuming that the specimen carrier is gripped by gripper 13, and gripper 23 is open (as shown), the high positional accuracy achieved guarantees that the other gripper 23 does not touch the specimen carrier. The specimen carrier 2, and thus the specimen 1, can now be transferred from gripper 13 to the other gripper 23 by closing gripper 23 and then opening gripper 13. The second holder 20 can then be retracted to another position, thereby transferring the specimen from a first position to a second position.

It is remarked that for the transfer mechanism according to the invention to work properly, at least one of the axles must show a certain amount of play, so that the axles can position with respect to each other.
It is further remarked that grippers of other models or types than the one referred to before can be used. Grippers based on e.g. piezo-effect, electrostatic force or magnetic force are known to work, as well as grippers based on mechanical movement caused by e.g. electric motors.
It is also remarked that, although this embodiment discusses a specimen mounted on a TEM grid, which may be inspected in a TEM, the invention also relates to other specimens or specimen carriers and that the transfer mechanism can also interface with e.g. a Scanning Electron Microscope (SEM), a Focused Ion Beam instrument (FIB) or with e.g. an instrument that uses both ion and electron beams. Also instruments using transfer mechanisms for other purposes may interface with or be equipped with the transfer mechanism described.

Figure 2 shows schematically a cross-section of the transfer mechanism according to the invention, in which the holders cooperate with a separate member to form the mechanical guidance system.
The specimen 1 is mounted on a TEM specimen grid 2 in a fashion known to the person skilled in the art.
Separate member 31 shows an inner surface 32 and end-faces 33^{a} and 33^{b}.
A first holder 10 comprises an axle 11 with an extremity 12. Extremity 12 is equipped with a gripper 13. The surface 17^{a}, 17^{b} of extremity 12 is formed to cooperate with the inner surface 32 of the separate member 31, while end-face 18 is formed to cooperate with end-face 33^{a} of the separate member 31.
A second holder 20 comprises an axle 21 with an extremity 22. Extremity 22 is equipped with a gripper 23. The surface 27^{a}, 27^{b} of extremity 22 is formed to cooperate with the inner surface 32 of the separate member 31, while end-face 28 is formed to cooperate with end-face 33^{b} of the separate member 31.

When the two holder 10 and 20 are moved towards each other, they are first centred by surfaces 17^{b} and 27^{b} contacting the inner surface 32 of the separate member. After that the surfaces 17^{a} and 27^{a}, contacting the inner surface 32 of the separate member 31, also align the two holders with respect to each other. The distance between the grippers is dictated by faces 18 and 33^{a} respectively 28 and 33^{b} contacting each other.
It is remarked that separate member 31 can be a section of a round tube, but can also be a section of a tube with e.g. a rectangular cross-section. In the latter case also the rotational degree of freedom of the holders along their common axis is prescribed.
It is further remarked that separate member 31 can be connected to a part of the apparatus of which the transfer mechanism is part, but no high positional demands of this separate member with respect to the holders or with respect to the apparatus are needed: as long as surfaces 17^{b} and 27^{b} can enter the separate member, after which surfaces 17^{a} and 27^{a} will contact inner surface 32 of the separate member, the two holders will be positioned correctly for transfer. It is also remarked that separate member 31 need not be one part: it can also be equipped as e.g. two parts movable with respect to each other, clamping around the two holders when closing.

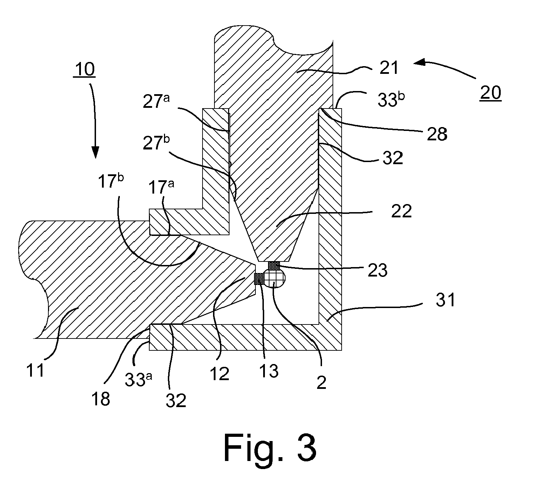

Figure 3 schematically depicts a cross-section of the transfer mechanism according to the invention, in which the specimen is transferred between two axles moving perpendicular to each other.
Figure 3 can be thought to be derived from figure 2. The end-face 33^{b} and that part of the inner surface 32 which dictate the position of holder 20 when that holder is inserted in the separate member 31 are now turned at right angles with respect to the end-face 33^{a} and that part of the inner surface dictating the position of holder 10.
It will be clear to the person skilled in the art that grippers 13 and 23 are viewed at another angle than in figure 2, and that the sample carrier 2 is thus depicted at another angle as well.

It is remarked that the axles need not be in-line (as shown in figure 2) or perpendicular (as shown in figure 3), but that a transfer mechanism with an arbitrary angle between the axles can be constructed.

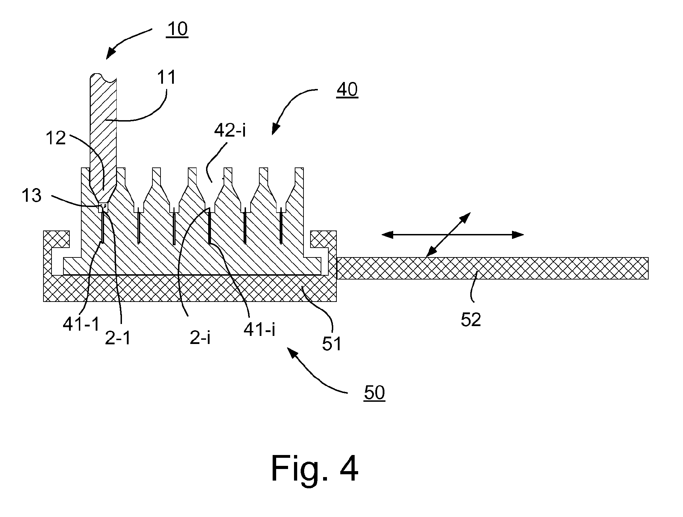

Figure 4 schematically depicts a cross-section a cross-section of the transfer mechanism according to the invention, in which one of the holders is equipped to hold a multitude of specimens.
Holder 10 comprises an axle 11 with an extremity 12. Extremity 12 is equipped with a gripper 13.
Cassette 40 is a holder for specimen carriers comprises a plurality of slots 41-i in which a plurality of specimen carriers 1-i may be placed. Each of the slots 41-i connect to a cone-like recess 42-i. The surfaces of the cone-like recesses 42-i are intended to cooperate with the surface of extremity 12 in such a way that, when extremity 12 is inserted fully into one of the recesses 42-i, the gripper mounted on axle 11 is precisely positioned with respect to slot 41-i, and thus with specimen carrier 1-i.
Cassette 40 is ram-shackled connected to a cassette manipulator 50, thereby giving cassette 40 play to position itself with respect to holder 10 when extremity 12 of holder 10 is inserted in cassette 40. Cassette manipulator 50 comprises a body 51 in which cassette 40 is mounted, and an axle 52 to position body 51 with respect to holder 10.
The axle 52 of the cassette manipulator 50 can position cassette 40 with sufficient accuracy so that holder 10 can be inserted into a specific recess 42-i. The accurate positioning of the gripper 13 with respect to the recess 42-i is accomplished by the cooperating surfaces of extremity 12 and recess 42-i. Thus a specific specimen carrier 2-i can be picked out of cassette 40.
It is remarked that by preference cassette 40 is detachably mounted in cassette manipulator 50, so that the cassette can be exchanged by another cassette.
It is further remarked that it is not necessary that both holders are movable. Especially when using a cassette it is conceivable that the cassette is kept stationary.

## Claims

1. Transfer mechanism for transferring a specimen (1) from a first position in a first holder (10) to a second position in a second holder (20) and/or vice versa, each holder (10, 20) equipped to detachably hold the specimen (1), the transfer of the specimen (1) between the holders (10, 20) taking place in a transfer position different from the second position, **characterized in that** when the specimen (1) is transferred between the holders (10, 20) a mechanical guidance mechanism positions the holders (10, 20) with a mutual accuracy higher than the mutual accuracy in the second position, and said mechanical guidance mechanism not positioning at least one of the holders when the specimen is in the second position.

2. Transfer mechanism according to claim 1 in which the mechanical guidance mechanism is formed by the cooperation of the shape of the holders (10, 20).

3. Transfer mechanism according to claim 1 in which the mechanical guidance mechanism is formed by the cooperation of the two holders with a separate member (31), said member detachably contacted by both holders (10, 20) when the specimen (1) is transferred.

4. Transfer mechanism according to any of the preceding claims in which at least one holder (40) is equipped to hold a multitude of specimens (1-i).

5. Transfer mechanism according to any of the preceding claims in which the transfer mechanism is equipped to operate in a vacuum environment.

6. Transfer mechanism according to any of the preceding claims in which the mutual accuracy of the holders (10, 20) during the transfer of the specimen must be less than 50 µm in any direction.

7. Apparatus equipped with a transfer mechanism according to any of the preceding claims.

8. Apparatus according to claim 7 in which the apparatus is a particle-optical apparatus.
